# FASCICULE DE BREVET EUROPEEN

(11) **EP 2 241 010 B1**
(45) Date de publication et mention de la délivrance du brevet: **28.02.2018**
(21) Numéro de dépôt: 08857306.8
(22) Date de dépôt: 03.12.2008
(51) Int. Cl.: H03M 1/06, H03M 1/66

(54) **DISPOSITIF DE RESYNCHRONISATION DE SIGNAUX ANALOGIQUES OBTENUS PAR CONVERSION, AVEC DES CONVERTISSEURS NUMERIQUE-ANALOGIQUE DDR, DE SIGNAUX NUMERIQUES SYNCHRONISES**
VORRICHTUNG ZUR ERNEUTEN SYNCHRONISIERUNG ANALOGER SIGNALE MITTELS UMSETZUNG DURCH DDR-DIGITAL-ANALOG-WANDLER VON SYNCHRONISIERTEN DIGITALEN SIGNALEN
DEVICE FOR RESYNCHRONISING ANALOG SIGNALS OBTAINED BY CONVERSION USING DDR DIGITAL-TO-ANALOG CONVERTERS OF SYNCHRONISED DIGITAL SIGNALS

(30) Priorité: 07.12.2007 FR 0708550
(43) Date de publication de la demande: 20.10.2010
(73) Titulaire: THALES, 92400 Courbevoie (FR)
(72) Inventeur: AUTRUSSON, Bertrand, F-92290 Chatenay Malabry (FR); PASSELAIGUE, Daniel, F-78580 Maule (FR); VERYERAS, Alexandre, F-78180 Montigny-le-Bretonneux (FR)
(74) Mandataire: Lucas, Laurent Jacques
(86) Numéro de dépôt international: PCT/EP2008/066677
(87) Numéro de publication internationale: WO 2009/071568

(56) Documents cités:
- "Synchronizing Multiple High-Speed Multiplexed DACs for Transmit Applications" , [Online] 21 septembre 2006 (2006-09-21) , pages 1-6, XP002492319 MAXIM Application Notes Extrait de l'Internet: URL:www.maxim-ic.com/an3901> [extrait le 2008-08-14]

## Description

La présente invention concerne un dispositif de resynchronisation d'une pluralité de signaux analogiques obtenus par conversion, avec des convertisseurs numérique-analogique à rythme de données double, d'une pluralité de signaux numériques synchronisés en sortie d'un composant numérique. Elle s'applique par exemple dans le domaine de l'électronique.

La conversion en analogique de signaux numériques à haute fréquence d'échantillonnage a toujours posé des problèmes, à cause notamment de phénomènes physiques rémanents sur des composants internes aux convertisseurs numérique-analogiques (CNA). Une solution actuelle est l'utilisation de CNA fonctionnant conformément au protocole à rythme de données double, ce protocole étant plus connu par l'acronyme anglo-saxon « DDR » signifiant « Double Data Rate ». Le principe du protocole DDR est d'utiliser les fronts montants et les fronts descendants d'un signal d'horloge au lieu d'utiliser uniquement ses fronts montants. Concrètement, pour faire travailler un CNA sur des signaux numériques de fréquence d'échantillonnage 2F, le CNA reçoit un signal d'horloge de fréquence 2F en entrée, qu'il divise par deux par des mécanismes internes afin d'obtenir un signal d'horloge de fréquence F. Le signal de fréquence F est utilisé par le CNA pour cadencer ses étages de registres, notamment ses registres d'entrée recevant le signal numérique à convertir. D'une part, en travaillant sur les fronts montants et sur les fronts descendants du signal de fréquence F conformément au protocole DDR, ces étages de registres peuvent traiter un signal numérique d'entrée échantillonné à la fréquence 2F. D'autre part, en travaillant à la fréquence F au lieu de travailler à la fréquence 2F, ces étages de registres limitent l'impact des phénomènes physiques rémanents. Par la suite, un CNA fonctionnant conformément au protocole DDR sera simplement appelé CNA DDR.

Dans certaines situations, plusieurs signaux numériques synchronisés et de même fréquence élevée peuvent devoir être convertis en signaux analogiques, de telle manière que les dits signaux analogiques doivent rester synchronisés. Il peut alors être intéressant de faire travailler en parallèle plusieurs CNA DDR recevant un même signal d'horloge. Par exemple, en considérant deux signaux numériques synchronisés de fréquence élevée 2F, ces deux signaux peuvent être fournis en entrée de deux CNA DDR respectivement, les deux CNA DDR recevant un même signal d'horloge de fréquence 2F. Mais malheureusement, malgré le fait qu'ils reçoivent un même signal d'horloge de fréquence 2F, il n'y a aucune raison pour que les signaux de fréquence F obtenus par division en interne de chacun des deux CNA DDR soient en phase. Les signaux de fréquence F obtenus par division par deux en interne de chacun des deux CNA DDR peuvent être en opposition de phase l'un par rapport à l'autre. En effet, ces divisions du signal étant réalisées indépendamment l'une de l'autre par des composants électroniques certes identiques mais distincts, il n'y a aucune raison pour qu'elles donnent des signaux identiques en phase. Dans le cas présent, cela peut s'expliquer par des temps de latence spécifiques à chaque composant électronique qui, malgré un même signal d'horloge, décalent dans le temps les CNA DDR dès leurs démarrages. Ainsi, les divisions par deux peuvent se faire sur des phases différentes du signal d'horloge de fréquence 2F et les signaux de fréquence F se retrouvent en opposition de phase. Les signaux analogiques convertis en sortie des deux CNA DDR se retrouvent eux aussi en opposition de phase. Par ailleurs, il faut noter que ce phénomène n'est pas déterministe et que d'une mise sous tension à une autre des deux CNA DDR, malgré des conditions de mise sous tension qui peuvent sembler identiques, ils peuvent être en phase ou en opposition de phase sans qu'il soit possible de prévoir.

Le problème semble avoir été identifié par des fabricants de CNA DDR, certains ayant même publié des notes techniques visant à donner des pistes et des conseils aux utilisateurs confrontés au problème. Il s'agit essentiellement de prendre garde de faire fonctionner les CNA DDR dans des environnements similaires tant que faire se peut, par exemple en prenant notamment soin de soumettre les lignes véhiculant le signal d'horloge aux mêmes contraintes. Mais les tentatives dans ce sens menées par la demanderesse avec l'assistance des fabricants n'ont pas abouti. Un fabricant envisage de produire prochainement un dispositif comportant deux CNA DDR sur une même puce ce qui, d'après le fabricant en question, devrait résoudre le problème puisque les deux CNA DDR partageront les composants de démarrage suspectés d'être à l'origine du problème. Mais cette solution n'est pas encore disponible actuellement.

Dans une note technique intitulée « Synchronizing Multiple High-Speed Multiplexed DACs for Transmit Applications » disponible sur le site internet de la société MAXIM, une solution est divulguée pour détecter puis corriger l'opposition de phase entre deux CNA DDR utilisés pour convertir en analogique deux sorties synchronisées d'un composant numérique. Mais cette solution nécessite l'ajout d'un composant dédié que distribue la société MAXIM.

L'invention a notamment pour but de résoudre le problème précité, en exploitant judicieusement l'architecture matérielle des CNA DDR. A cet effet, l'invention a pour objet un dispositif de resynchronisation tel que défini par les revendications.

L'invention a encore pour principaux avantages qu'elle ne nécessite pas un mécanisme pour détecter dans un premier temps une opposition de phase et un mécanisme pour corriger dans un deuxième temps une éventuelle opposition de phase. L'invention fournit une solution simple, unitaire et autonome qui fonctionne de manière identique qu'il y ait opposition de phase ou pas

D'autres caractéristiques et avantages de l'invention apparaîtront à l'aide de la description qui suit faite en regard de dessins annexés qui représentent :
- la figure 1, une illustration par un synoptique d'un exemple d'architecture matérielle d'un CNA DDR ;
- la figure 2, une illustration d'exemples de signaux pouvant résulter de la division par deux d'un signal d'horloge ;
- la figure 3, une illustration par un synoptique d'un exemple de dispositif selon l'invention.

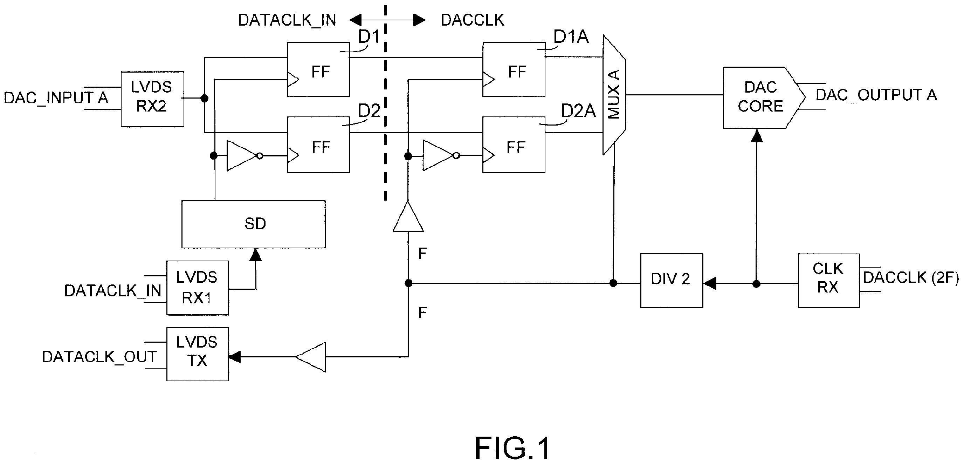

La figure 1 illustre par un synoptique un exemple d'architecture matérielle d'un CNA DDR A. Le CNA DDR A de la figure 1 est un CNA DDR de marque Analog Device de type AD9736. Il comporte un élément CLKRX qui peut recevoir de l'extérieur un signal d'horloge DACCLK à la fréquence 2F. Un élément DIV2 divise par deux la fréquence de DACCLK pour obtenir un signal d'horloge DATACLK_OUT de fréquence F, le signal d'horloge DATACLK_OUT étant d'une part fourni en sortie par l'intermédiaire d'un composant LVDSTX et le signal d'horloge DATACLK_OUT étant d'autre part fourni à des registres de sortie D1A et D2A internes au CNA DDR A. Les registres D1A et D2A sont donc cadencés à la fréquence F. Le CNA DDR A de l'exemple de la figure 1 comporte également un élément LVDSRX1 qui peut recevoir de l'extérieur un signal d'horloge DATACLK_IN. Le signal d'horloge DATACLK_IN est fourni à des registres d'entrée D1 et D2 par l'intermédiaire d'un élément SD d'échantillonnage. Les registres D1 et D2 peuvent recevoir par l'intermédiaire d'un élément LVDSRX2 un signal numérique DAC_INPUTA à convertir. Pour convertir correctement le signal numérique DAC_INPUTA, les registres D1 et D2 doivent être synchronisés avec les registres de sortie du composant extérieur fournissant le signal DAC_INPUTA. En d'autres termes, le signal d'horloge DATACLK_IN doit être identique au signal qui cadence les registres de sortie du composant qui fournit le signal numérique DAC_INPUTA à convertir. Le CNA DDR A comporte également un multiplexeur MUXA qui permet de traiter alternativement les registres D1A et D2A et de fournir les données qu'ils contiennent à un élément DACCORE. L'élément DACCORE fournit en sortie du CNA DDR A un signal analogique DAC_OUTPUTA qui est la conversion du signal DAC_INPUTA. L'architecture du CNA DDR A apparaît clairement séparée en deux domaines : un domaine où les étages de registres sont cadencés à la fréquence DATACLK_IN et un domaine où les étages de registres sont cadencés à la fréquence DACCLK. L'invention se propose d'exploiter judicieusement cette propriété que l'on retrouve dans la majorité des CNA DDR.

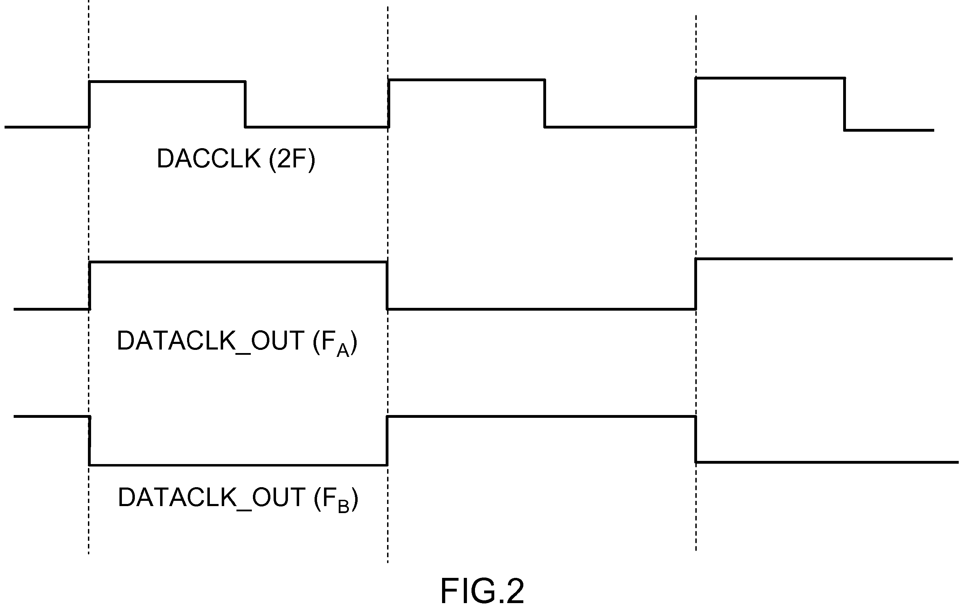

La figure 2 illustre les deux signaux DATACLK_OUT pouvant résulter de la division par deux du signal DACCLK par le composant DIV2. Comme explicité précédemment, la division réalisée par DIV2 peut se faire sur des phases différentes du signal DACCLK de fréquence 2F, ceci de manière indéterministe. Ainsi, deux signaux DATACLK_OUT peuvent résulter de la division du signal DACCLK : soit un signal DATACLK_OUT de fréquence F_{A}, soit un signal DATACLK_OUT de fréquence F_{B}, les fréquences F_{A} et F_{B} étant en opposition de phase.

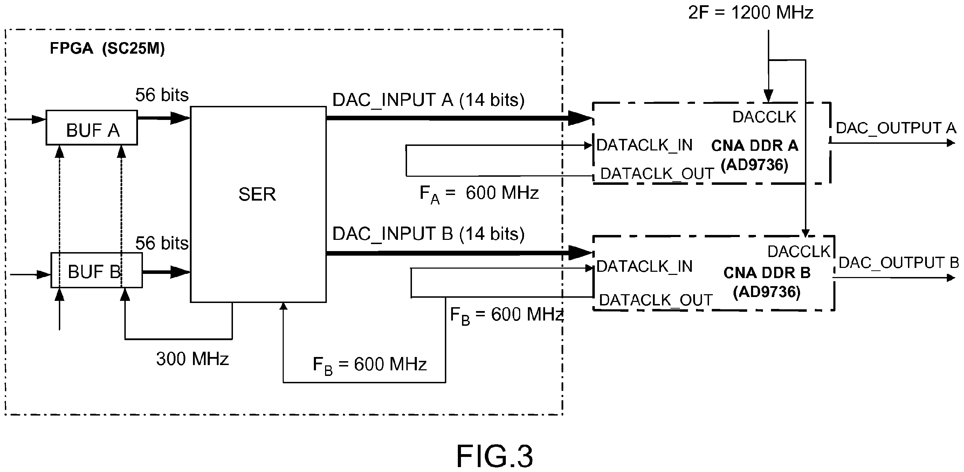

La figure 3 illustre par un synoptique un exemple de dispositif selon l'invention. Le dispositif comporte deux CNA DDR identiques de type AD9736, le CNA DDR A de la figure 1 et un CNA DDR B, pour traiter parallèlement deux signaux numériques DAC_INPUTA et DAC_INPUTB synchronisés de 14 bits chacun. Ces deux signaux numériques DAC_INPUTA et DAC_INPUTB synchronisés peuvent être fournis par un réseau de portes programmables, ou « FPGA » selon la terminologie anglo-saxonne (« field-programmable gate array »). Par exemple, le FPGA peut être de marque Lattice de la famille SC25M. Il peut comporter deux tampons de mémoire BUF A et BUF B de type FIFO (« First In First Out ») pouvant recevoir par exemple deux flots de données de 56 bits chacun, ceci de manière discontinue. Le FPGA peut comporter un module SER de sérialisation des données vers lequel sont transférés les flots de données de 56 bits. Par exemple, le module SER peut permettre de passer de deux bus 56 bits à 300 mégahertz en entrée à deux bus 14 bits avec une horloge quatre fois plus rapide en sortie, c'est-à-dire une horloge à 1200 mégahertz.

Le CNA DDR A et le CNA DDR B doivent donc convertir les deux signaux numériques synchronisés de 14 bits à 1200 mégahertz, de telle sorte que les deux signaux analogiques DAC_OUTPUTA et DAC_OUTPUTB en sortie de CNA DDR A et de CNA DDR B respectivement soient toujours synchronisés. Pour cela, le CNA DDR A et le CNA DDR B reçoivent en entrée de leurs éléments CLKRX respectifs le même signal d'horloge DACCLK à la fréquence 2F de la figure 2 avec 2F=1200 mégahertz. Dans l'exemple de la figure 3, le signal à F=600 mégahertz en sortie DATACLK_OUT du CNA DDR B peut avantageusement être fourni comme signal d'horloge des registres de sortie du module SER. En effet, les sorties du module SER étant traitées par des composants DDR, à savoir le CNA DDR A et le CNA DDR B, une horloge à 600 mégahertz au lieu de 1200 mégahertz suffit. Car comme explicité précédemment, une horloge à 600 mégahertz utilisée en DDR est équivalente à une horloge à 1200 mégahertz utilisée en rythme de données simple. Ainsi, selon l'invention, les données sont envoyées vers la sortie du module SER avec une horloge synchrone du CNA DDR B, qui sera appelé par la suite « convertisseur de référence ». Par ailleurs, chacun des signaux d'horloge aux sorties DATACLK_OUT peut être renvoyé à son propre convertisseur : le signal à la fréquence F=600 mégahertz en sortie DATACLK_OUT du CNA DDR B est fourni comme signal d'horloge à l'entrée DATACLK_IN du CNA DDR B et le signal à la fréquence F=600 mégahertz en sortie DATACLK_OUT du CNA DDR A est fourni comme signal d'horloge à l'entrée DATACLK_IN du CNA DDR A. Mais comme explicité précédemment, malgré le fait qu'ils reçoivent le même signal d'horloge DACCLK à la fréquence 2F=1200 mégahertz et le fait que les lignes véhiculant ce signal soient soumises aux mêmes contraintes, il n'y a aucune raison pour que les deux signaux de fréquence F=600 mégahertz disponibles sur les sorties DATACLK_OUT respectives du CNA DDR A et du CNA DDR B soient en phase.

Dans un premier cas, qui est celui illustré par la figure 3, ils peuvent être en opposition de phase, le signal à la sortie DATACLK_OUT du CNA DDR A pouvant être à la fréquence F_{A} de la figure 2 et le signal à la sortie DATACLK_OUT du CNA DDR B pouvant être à la fréquence F_{B} de la figure 2. Comme illustré par la figure 1, le multiplexeur MUXA traite alternativement les données en sortie du registre D1A puis les données en sortie du registre D2A, les registres D1A et D2A ainsi que le multiplexeur MUXA étant eux-même cadencés en interne du CNA DDR A à la fréquence F_{A}. De manière similaire, le CNA DDR B comporte un multiplexeur MUXB qui traite alternativement les données en sortie d'un registre D1B puis les données en sortie d'un registre D2B, les registres D1B et D2B ainsi que le multiplexeur MUXB étant eux-même cadencés en interne du CNA DDR B à la fréquence F_{B}. Mais puisque par hypothèse F_{A} et F_{B} sont en opposition de phase, alors MUXA et MUXB travaillent de manière symétrique ou inversée : MUXA traite D1A quand MUXB traite D2B et MUXA traite D2A quand MUXB traite D1 B. Or, les sorties du module SER sont quant à elles cadencées à la fréquence F_{B}, le CNA DDR B étant le convertisseur de référence fournissant le signal d'horloge au module SER. Donc les registres d'entrée D1 et D2 du CNA DDR A cadencés à F_{A} travaillent également de manière inversée ou symétrique par rapport aux registres de sortie du module SER : le registre D1A se retrouve à contenir ce qu'aurait dû contenir le registre D2A et le registre D2A se retrouve à contenir ce qu'aurait dû contenir le registre D1A. Cette inversion du contenu des registres D1A et D2A combinée avec l'inversion dans le séquencement des traitements par MUXA des registres D1A et D2A permet de rétablir la synchronisation. En quelque sorte, une inversion annule l'autre.

Dans un deuxième cas, les signaux de fréquence F=600 mégahertz disponibles sur les sorties DATACLK_OUT respectives du CNA DDR A et du CNA DDR B peuvent être en phase, le signal à la sortie DATACLK_OUT du CNA DDR A et le signal à la sortie DATACLK_OUT du CNA DDR B pouvant être à la même fréquence F_{A} de la figure 2. Dans ce cas, il n'y a plus aucune inversion et la synchronisation n'est jamais rompue.

Dans un deuxième cas, les signaux de fréquence F=600 mégahertz disponibles sur les sorties DATACLK_OUT respectives du CNA DDR A et du CNA DDR B peuvent être en phase, le signal à la sortie DATACLK_OUT du CNA DDR A et le signal à la sortie DATACLK_OUT du CNA DDR B pouvant être à la même fréquence F_{B} de la figure 2. Dans ce cas également, il n'y a plus aucune inversion et la synchronisation n'est jamais rompue.

Ainsi, grâce à l'invention, les signaux analogiques convertis en sortie des deux CNA DDR A et CNA DDR B sont toujours en phase, ils ne sont jamais désynchronisés.

Outre l'avantage d'offrir une solution simple, unitaire, autonome et peu coûteuse, l'invention décrite précédemment a encore pour principaux avantages qu'elle est applicable quel que soit le nombre de CNA DDR utilisés, un seul d'entre eux constituant le convertisseur de référence pour tous les autres. Indépendante de la fréquence, elle est par ailleurs applicable à des fréquences élevées.

## Revendications

1. Dispositif de resynchronisation d'une pluralité de signaux analogiques (DAC_OUTPUTA, DAC_OUTPUTB) obtenus par conversion, avec des convertisseurs numérique-analogique à rythme de données double, d'une pluralité de signaux numériques (DAC_INPUTA, DAC_INPUTB) de fréquence 2F synchronisés en sortie d'un module de sérialisation (SER) :
- le dispositif comportant au moins deux convertisseurs numérique-analogique A et B à rythme de données double, chaque convertisseur étant connecté respectivement à une voie de sortie dudit module de sérialisation :
- les convertisseurs A et B recevant un même signal d'horloge de fréquence 2F, les convertisseurs A et B divisant par deux de manière indépendante ce signal d'horloge, pour obtenir un signal d'horloge de fréquence F permettant de cadencer à la fréquence F leurs registres de sortie (D1A, D2A) et leurs registres d'entrée (D1, D2) ;
ledit dispositif étant **caractérisé en ce que** le convertisseur B fournit le signal d'horloge à la fréquence F audit module de sérialisation (SER) pour cadencer les registres de sortie dudit module de sérialisation (SER), la sortie d'horloge du convertisseur B fournissant le signal d'horloge des registres de sortie dudit module de sérialisation (SER), de sorte que les signaux analogiques (DAC_OUTPUTA, DAC_OUTPUTB) en sortie des deux convertisseurs A et B restent synchronisés même si le signal d'horloge à la fréquence F_{A} obtenu par division dans le convertisseur A est en opposition de phase par rapport au signal d'horloge à la fréquence F_{B} obtenu par division dans le convertisseur B.

2. Dispositif selon la revendication 1, **caractérisé en ce que** :
- les convertisseurs A et B comportent chacun une sortie d'horloge (DATACLK_OUT) fournissant le signal d'horloge à la fréquence F ;
- les convertisseurs A et B comportent chacun une entrée d'horloge (DATACLK_IN) permettant de cadencer leurs registres d'entrée (D1, D2) ;
- la sortie d'horloge du convertisseur A est connectée à l'entrée d'horloge du convertisseur A et la sortie d'horloge du convertisseur B est connectée à l'entrée d'horloge du convertisseur B ;

3. Dispositif selon la revendication 1, **caractérisé en ce que** le module de sérialisation (SER) est implémenté dans un réseau de portes programmables (FPGA).

4. Dispositif selon la revendication 1, **caractérisé en ce que** le module de sérialisation (SER) permet de passer de signaux numériques sur 56 bits à des signaux sur 14 bits en multipliant la fréquence des signaux par quatre.

5. Dispositif selon la revendication 1, **caractérisé en ce que** la fréquence 2F est supérieure à 1000 mégahertz.

## Patentansprüche

1. Vorrichtung zum erneuten Synchronisieren einer Mehrzahl von Analogsignalen (DAC_OUTPUTA, DAC_OUTPUTB), erhalten durch Umwandeln, mit Doppeldatenraten-Digital/Analog-Wandlern, einer Mehrzahl von digitalen Signalen (DAC_INPUTA, DAC_INPUTB) mit einer Frequenz 2F, synchronisiert am Ausgang eines Serialisierungsmoduls (SER):
- wobei die Vorrichtung wenigstens zwei Doppeldatenraten-Digital/AnalogWandler A und B umfasst, wobei jeder Wandler jeweils mit einem Ausgangskanal des Serialisierungsmoduls verbunden ist;
- wobei die Wandler A und B ein selbes Taktsignal mit der Frequenz 2F empfangen, wobei die Wandler A und B dieses Taktsignal unabhängig durch zwei dividieren, um ein Taktsignal mit der Frequenz F zu erhalten, so dass ihre Ausgangsregister (D1A, D2A) und ihre Eingangsregister (D1, D2) auf die Frequenz F getaktet werden können;
wobei die Vorrichtung **dadurch gekennzeichnet ist, dass** der Wandler B dem Serialisierungsmodul (SER) das Taktsignal mit der Frequenz F zuführt, um die Ausgangsregister des Serialisierungsmoduls (SER) zu takten, wobei der Taktausgang des Wandlers B das Taktsignal der Ausgangsregister des Serialisierungsmoduls (SER) zuführt, so dass die Analogsignale (DAC_OUTPUTA, DAC_OUTPUTB) am Ausgang der beiden Wandler A und B selbst dann synchronisiert bleiben, wenn das durch Dividieren im Wandler A erhaltene Taktsignal mit der Frequenz F_{A} gegenphasig zu dem durch Dividieren im Wandler B erhaltenen Taktsignal mit der Frequenz F_{B} ist.

2. Vorrichtung nach Anspruch 1, **dadurch gekennzeichnet, dass**:
- die Wandler A und B jeweils einen das Taktsignal mit der Frequenz F zuführenden Taktausgang (DATACLK_OUT) umfassen;
- die Wandler A und B jeweils einen Takteingang (DATACLK_IN) umfassen, der das Takten ihrer Eingangsregister (D1, D2) zulässt;
- der Taktausgang des Wandlers A mit dem Takteingang des Wandlers A verbunden ist und der Taktausgang des Wandlers B mit dem Takteingang des Wandlers B verbunden ist.

3. Vorrichtung nach Anspruch 1, **dadurch gekennzeichnet, dass** das Serialisierungsmodul (SER) in einem Netzwerk von programmierbaren Gates (FPGA) implementiert ist.

4. Vorrichtung nach Anspruch 1, **dadurch gekennzeichnet, dass** das Serialisierungsmodul (SER) das Übersetzen von digitalen Signalen auf 56 Bits in Signale auf 14 Bits durch Multiplizieren der Frequenz der Signale mit vier zulässt.

5. Vorrichtung nach Anspruch 1, **dadurch gekennzeichnet, dass** die Frequenz 2F höher ist als 1000 Megahertz.

## Claims

1. A device for resynchronizing a plurality of analogue signals (DAC_OUTPUTA, DAC_OUTPUTB) obtained by converting, using double data rate digital-to-analogue converters, a plurality of digital signals (DAC_INPUTA, DAC_INPUTB) of frequency 2F synchronised at the output of a serialisation module (SER):
- the device comprising at least two double data rate digital-analogue converters A and B, each converter being respectively connected to an output channel of said serialisation module;
- the converters A and B receiving the same clock signal of frequency 2F, the converters A and B independently dividing this clock signal by two, in order to obtain a clock signal of frequency F allowing their output registers (D1A, D2A) and their input registers (D1, D2) to be clocked to the frequency F;
said device being **characterised in that** the converter B supplies said serialisation module (SER) with the clock signal at the frequency F in order to clock the output registers of said serialisation module (SER), the clock output of the converter B supplying the clock signal of the output registers of said serialisation module (SER), so that the analogue signals (DAC_OUTPUTA, DAC_OUTPUTB) at the output of the two converters A and B remain synchronised even if the clock signal at the frequency F_{A} obtained by division in the converter A is in phase opposition relative to the clock signal at the frequency F_{B} obtained by division in the converter B.

2. The device as claimed in claim 1, **characterised in that**:
- the converters A and B each comprise a clock output (DATACLK_OUT) supplying the clock signal at the frequency F;
- the converters A and B each comprise a clock input (DATACLK_IN) allowing their input registers (D1, D2) to be clocked;
- the clock output of the converter A is connected to the clock input of the converter A and the clock output of the converter B is connected to the clock input of the converter B.

3. The device as claimed in claim 1, **characterised in that** the serialisation module (SER) is implemented in an array of programmable gates (FPGA).

4. The device as claimed in claim 1, **characterised in that** the serialisation module (SER) allows switching from digital signals on 56 bits to signals on 14 bits by multiplying the frequency of the signals by four.

5. The device as claimed in claim 1, **characterised in that** the frequency 2F is greater than 1,000 megahertz.
